# EUROPEAN PATENT APPLICATION

(11) **EP 2 355 161 A2**
(43) Date of publication of application: **10.08.2011**
(21) Application number: 11000243.3
(22) Date of filing: 13.01.2011
(51) Int. Cl.: H01L 31/0216, H01L 31/075

(54) **Solar cell**

(30) Priority: 03.02.2010 KR 20100010024
(71) Applicant: LG ELECTRONICS INC., Yeongdeungpo-gu Seoul 150-721 (KR)
(72) Inventor: Moon, Taeho, Seoul 137-724 (KR); Eo, Youngjoo, Seoul 137-724 (KR); Lee, Heonmin, Seoul 137-724 (KR); Yoon, Wonki, Seoul 137-724 (KR); Ahn, Sehwon, Seoul 137-724 (KR)
(74) Representative: Frenkel, Matthias Alexander

(57) **Abstract**

A solar cell is discussed. The solar cell includes a substrate, a photoelectric transformation unit including at least one semiconductor layer, a transparent electrode positioned between the substrate and the photoelectric transformation unit, and a buffer layer positioned between the transparent electrode and the substrate. The photoelectric transformation unit includes at least one p-type semiconductor layer, at least one n-type semiconductor layer, and at least one i-type semiconductor layer.

## Description

This application claims priority to and the benefit of Korean Patent Application No. 10-2010-0010024 filed in the Korean Intellectual Property Office on February 3, 2010, the entire content of which is incorporated herein by reference.

### BACKGROUND OF THE INVENTION

### Field of the Invention

Embodiments of the invention relate to a solar cell.

### Description of the Related Art

Recently, as existing energy sources such as petroleum and coal are expected to be depleted, interests in alternative energy sources for replacing the existing energy sources are increasing. Among the alternative energy sources, solar cells for generating electric energy from solar energy have been particularly spotlighted because the solar cells are able to draw energy from an abundant source and do not cause environmental pollution.

The solar cell is an element for converting light energy into electric energy and includes a p-type semiconductor and an n-type semiconductor.

When light coming from the outside is incident on the solar cell, a plurality of electron-hole pairs are formed inside the p-type and n-type semiconductors of the solar cell due to the incident light. Electrons move to the n-type semiconductor and holes move to the p-type semiconductor due to an electric field generated inside the solar cell. Hence, electric power is produced.

### SUMMARY OF THE INVENTION

In one aspect, there is a solar cell including a substrate, a photoelectric transformation unit including at least one semiconductor layer, a transparent electrode positioned between the substrate and the photoelectric transformation unit, and a buffer layer positioned between the transparent electrode and the substrate.

The photoelectric transformation unit may include at least one p-type semiconductor layer, at least one n-type semiconductor layer, and at least one i-type semiconductor layer.

The transparent electrode may contain ZnO:Al.

A refractive index of the buffer layer may be greater than a refractive index of the substrate and may be less than a refractive index of the transparent electrode. The refractive index of the buffer layer may be approximately 1.5 to 2.0.

The buffer layer may be formed of at least one of SiOxNy, SiOx, and SiNx.

The substrate may be a glass substrate.

The buffer layer may include a first portion, and a second portion positioned between the first portion and the transparent electrode, and a refractive index of the first portion may be less than a refractive index of a second portion.

A thickness of the buffer layer may be less than a thickness of the transparent electrode.

The buffer layer may include a first layer adjacent to the substrate and a second layer adjacent to the transparent electrode. A refractive index of the first layer may be less than a refractive index of the second layer. The refractive index of the first layer and the refractive index of the second layer may be greater than the refractive index of the substrate and may be less than the refractive index of the transparent electrode.

Alternatively, the buffer layer may include a first layer adjacent to the substrate, a second layer adjacent to the transparent electrode, and a third layer positioned between the first layer and the second layer. A refractive index of the third layer may be greater than a refractive index of at least one of the first layer and the second layer. The refractive indexes of the first, second, and third layers may be greater than the refractive index of the substrate and may be less than the refractive index of the transparent electrode.

The buffer layer may have a single-layered structure formed of one of SiOxNy, SiOx, and SiNx. Alternatively, the buffer layer may have a multi-layered structure formed of a SiOxNy layer and a SiOx layer. The buffer layer may have a multi-layered structure formed of a SiOx layer and a SiNx layer. The buffer layer may have a multi-layered structure formed of a SiOxNy layer and a SiNx layer. The buffer layer may have a multi-layered structure formed of a SiOxNy layer, a SiOx layer, and a SiNx layer. The SiOxNy layer may be positioned between the SiOx layer and the SiNx layer.

In another aspect, there is a solar cell including a substrate, a transparent electrode, a photoelectric transformation unit positioned between the transparent electrode and the substrate, and a buffer layer positioned on a light incident surface of the transparent electrode, and a refractive index of the buffer layer being less than a refractive index of the transparent electrode.

### BRIEF DESCRIPTION OF THE DRAWINGS

The accompanying drawings, which are included to provide a further understanding of the invention and are incorporated in and constitute a part of this specification, illustrate embodiments of the invention and together with the description serve to explain the principles of the invention. In the drawings:

FIGS. 1 to 11 relate to configurations of solar cells according to example embodiments of the invention;

FIGS. 12 to 18 relate to solar cells with a buffer layer having a multi-layered structure according to example embodiments of the invention;

FIG. 19 relates to another configuration of a solar cell having a buffer layer according to an example embodiment of the invention; and

FIGS. 20 to 22 relate to triple junction solar cells having a buffer layer according to example embodiments of the invention.

### DETAILED DESCRIPTION OF THE EMBODIMENTS

Embodiments of the invention will be described more fully hereinafter with reference to the accompanying drawings, in which example embodiments of the invention are shown. This invention may, however, be embodied in many different forms and should not be construed as limited to the embodiments set forth herein.

In the drawings, the thickness of layers, films, panels, regions, etc., are exaggerated for clarity. Like reference numerals designate like elements throughout the specification. It will be understood that when an element such as a layer, film, region, or substrate is referred to as being "on" another element, it can be directly on the other element or intervening elements may also be present. In contrast, when an element is referred to as being "directly on" another element, there are no intervening elements present. Further, it will be understood that when an element such as a layer, film, region, or substrate is referred to as being "entirely" on another element, it may be on the entire surface of the other element and may not be on a portion of an edge of the other element.

Reference will now be made in detail to embodiments of the invention, examples of which are illustrated in the accompanying drawings.

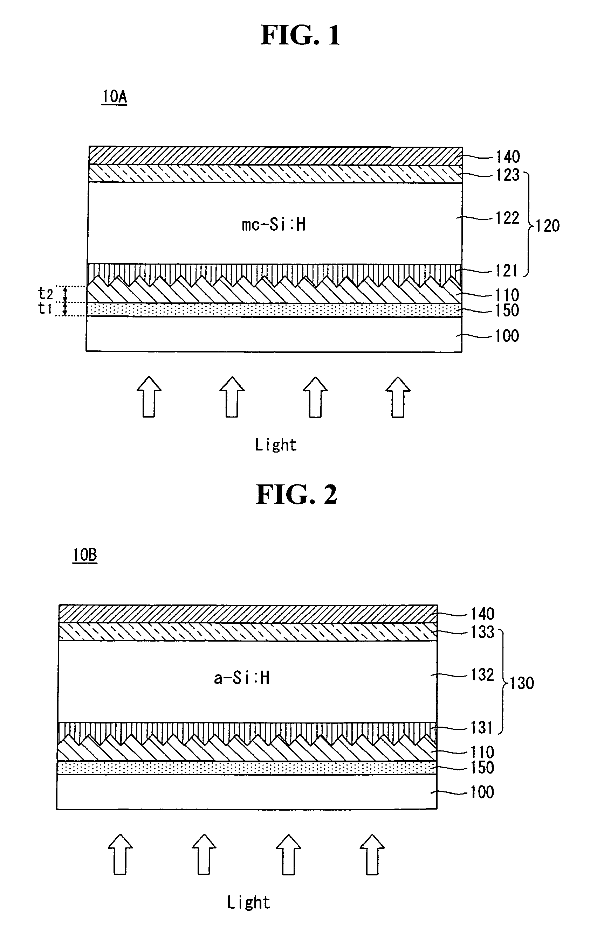

FIGS. 1 to 11 relate to configurations of solar cells according to example embodiments of the invention.

A structure of solar cells shown in FIGS. 1 and 2 may be referred to as a pin structure.

As shown in FIG. 1, a solar cell 10A according to an example embodiment of the invention may include a substrate 100, a front electrode 110, a back electrode 140, a photoelectric transformation unit 120, and a buffer layer 150. The buffer layer 150, the front electrode 110, the photoelectric transformation unit 120, and the back electrode 140 may be sequentially disposed on the substrate 100.

In the example embodiment of the invention, the front electrode 110 may be referred to as a first electrode, and the back electrode 140 may be referred to as a second electrode. Alternatively, the front electrode 110 may be referred to as a transparent electrode because it can transmit incident light.

The photoelectric transformation unit 120 is positioned between the front electrode 110 and the back electrode 140 to produce electric power using light coming from the outside. Further, the photoelectric transformation unit 120 may include at least one p-type semiconductor layer, at least one n-type semiconductor layer, and at least one i-type semiconductor layer. For example, as shown in FIG. 1, the photoelectric transformation unit 120 may include an intrinsic semiconductor layer 122 formed of microcrystalline silicon. The intrinsic semiconductor layer 122 may be referred to as an i-type semiconductor layer.

The substrate 100 may provide a space for other functional layers. The substrate 100 may be formed of a substantially transparent material, for example, glass or plastic, so that the incident light efficiently reaches the photoelectric transformation unit 120. It may be preferable, but not required, that the substrate 100 is a glass substrate so as to increase an affinity between the substrate 100 and the buffer layer 150.

The transparent electrode 110 (i.e., the front electrode 110) may contain a substantially transparent material with electrical conductivity so as to increase a transmittance of incident light. The transparent electrode 110 may be formed of a material having a high transmittance and the high electrical conductivity, so that the transparent electrode 110 transmits most of incident light and electricity smoothly flows in the transparent electrode 110. For example, the transparent electrode 110 may be formed of at least one selected from the group consisting of tin-based oxide (for example, SnO₂) AgO, ZnO-Ga₂O₃, Al₂O₃, fluorine tin oxide (FTO), and a combination thereof.

The transparent electrode 110 may be formed on the entire surface of the substrate 100 and may be electrically connected to the photoelectric transformation unit 120. Hence, the transparent electrode 110 may collect carriers (for example, holes) produced by the incident light and may output the carriers.

A plurality of uneven patterns having a non-uniform pyramid structure may be formed on an upper surface of the transparent electrode 110. In other words, the transparent electrode 110 may have a textured surface. As above, when the surface of the transparent electrode 110 is textured, the transparent electrode 110 may reduce a reflectance of incident light and increase an absorptance of light. Hence, the efficiency of the solar cell 10A may be improved.

Although FIG. 1 shows only the uneven portions of the transparent electrode 110, the photoelectric transformation unit 120 may have a plurality of uneven portions. In the embodiment of the invention, for example, only the uneven portions of the transparent electrode 110 is described below for the sake of brevity.

The buffer layer 150 may be positioned between the transparent electrode 110 and the substrate 100 to reduce a reflectance of incident light. The buffer layer 150 is described in detail later.

The back electrode 140 may be formed of metal with high electrical conductivity so as to increase a recovery efficiency of electric power produced by the photoelectric transformation unit 120. The back electrode 140 electrically connected to the photoelectric transformation unit 120 may collect carriers (for example, electrons) produced by incident light and may output the carriers.

The photoelectric transformation unit 120 may convert light from the outside into electrical energy. Preferably, but not necessarily, the photoelectric transformation unit 120 may be a silicon cell using microcrystalline silicon, for example, hydrogenated microcrystalline silicon (mc-Si:H). The photoelectric transformation unit 120 may include a p-type semiconductor layer 121, an intrinsic (called i-type) semiconductor layer 122, and an n-type semiconductor layer 123 that are sequentially formed on the transparent electrode 110 in the order named.

The p-type semiconductor layer 121 may be formed using a gas obtained by adding impurities of a group III element, such as boron (B), gallium (Ga), and indium (In), to a raw gas containing silicon (Si).

The i-type semiconductor layer 122 may prevent or reduce a recombination of carriers and may absorb light. The i-type semiconductor layer 122 may absorb incident light to produce carriers such as electrons and holes. The i-type semiconductor layer 122 may contain microcrystalline silicon, for example, hydrogenated microcrystalline silicon (mc-Si:H).

The n-type semiconductor layer 123 may be formed using a gas obtained by adding impurities of a group V element, such as phosphorus (P), arsenic (As), and antimony (Sb), to a raw gas containing silicon (Si).

The photoelectric transformation unit 120 may be formed using a chemical vapor deposition (CVD) method, such as a plasma enhanced CVD (PECVD) method.

In the photoelectric transformation unit 120, the p-type semiconductor layer 121 and the n-type semiconductor layer 123 may form a p-n junction with the i-type semiconductor layer 122 interposed therebetween. In other words, the i-type semiconductor layer 122 may be positioned between the p-type semiconductor layer 121 (i.e., a p-type doped layer) and the n-type semiconductor layer 123 (i.e., an n-type doped layer).

In such a structure of the solar cell 10, when light is incident on the p-type semiconductor layer 121, a depletion region is formed inside the i-type semiconductor layer 122 because of the p-type semiconductor layer 121 and the n-type semiconductor layer 123 each having a relatively high doping concentration, thereby generating an electric field. Electrons and holes generated in the i-type semiconductor layer 122 corresponding to a light absorbing layer are separated by a contact potential difference through a photovoltaic effect and move in different directions. For example, the holes may move to the transparent electrode 110 through the p-type semiconductor layer 121, and the electrons may move to the back electrode 140 through the n-type semiconductor layer 123. Hence, electric power may be produced.

Alternatively, as shown in FIG. 2, the photoelectric transformation unit 130 of the solar cell 10B according the embodiment of the invention may be a silicon cell using amorphous silicon (a-Si), for example, hydrogenated amorphous silicon (a-Si:H). In the structure of the photoelectric transformation unit 130 shown in FIG. 2, the intrinsic semiconductor layer 132 may contain amorphous silicon, for example, hydrogenated amorphous silicon (a-Si:H).

As discussed above with respect to FIG. 1, even if the intrinsic semiconductor layer 132 is formed of amorphous silicon, the buffer layer 150 may be positioned between the substrate 100 and the transparent electrode 110.

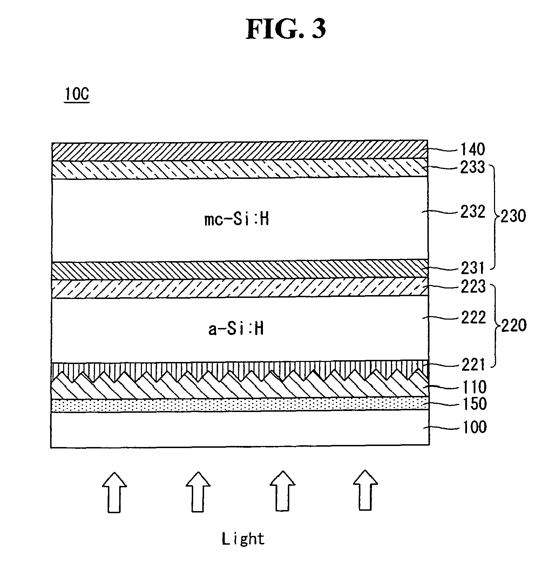

Alternatively, as shown in FIGS. 3 to 5, the solar cells 10C to 10E according the embodiments of the invention may have a double junction structure. The solar cells having the double junction structure may be referred to as a pin-pin solar cell.

As shown in FIG. 3, the solar cell 10C according to the embodiment of the invention may include a first photoelectric transformation unit 220 including a first i-type semiconductor layer 222 containing amorphous silicon and a second photoelectric transformation unit 230 including a second i-type semiconductor layer 232 containing microcrystalline silicon (mc-Si).

As shown in FIG. 3, in the solar cell 10C, a first p-type semiconductor layer 221, the first i-type semiconductor layer 222, a first n-type semiconductor layer 223, a second p-type semiconductor layer 231, the second i-type semiconductor layer 232, and a second n-type semiconductor layer 233 are sequentially stacked on a light incident surface of the substrate 100 in the order named.

The first photoelectric transformation unit 220 may include the first p-type semiconductor layer 221, the first i-type semiconductor layer 222, and the first n-type semiconductor layer 223. The second photoelectric transformation unit 230 may include the second p-type semiconductor layer 231, the second i-type semiconductor layer 232, and the second n-type semiconductor layer 233.

All of the first p-type semiconductor layer 221, the first i-type semiconductor layer 222, and the first n-type semiconductor layer 223 of the first photoelectric transformation unit 220 may contain amorphous silicon. All of the second p-type semiconductor layer 231, the second i-type semiconductor layer 232, and the second n-type semiconductor layer 233 of the second photoelectric transformation unit 230 may contain microcrystalline silicon. Alternatively, the first n-type semiconductor layer 223 of the first photoelectric transformation unit 220 may contain microcrystalline silicon.

The first i-type semiconductor layer 222 may mainly absorb light of a short wavelength band to produce electrons and holes. The second i-type semiconductor layer 232 may mainly absorb light of a long wavelength band to produce electrons and holes.

As discussed above for FIG. 3, because the double junction solar cell 10C absorbs light of the short wavelength band and light of the long wavelength band to produce carriers, the efficiency of the double junction solar cell 10C is improved.

Further, a thickness of the second i-type semiconductor layer 232 may be greater than a thickness of the first i-type semiconductor layer 222, so as to sufficiently absorb light of the long wavelength band.

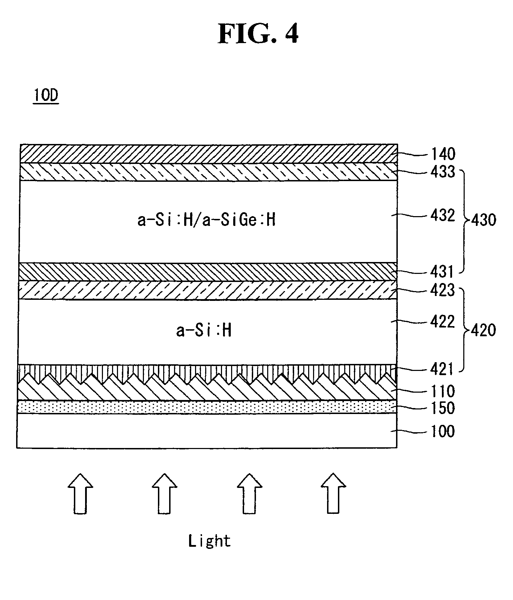

Alternatively, as shown in FIG. 4, the solar cell 10D having the double junction structure may include a first photoelectric transformation unit 420 including a first i-type semiconductor layer 422 containing amorphous silicon and a second photoelectric transformation unit 430 including a second i-type semiconductor layer 432 containing amorphous silicon. In other words, both the first i-type semiconductor layer 422 and the second i-type semiconductor layer 432 may contain amorphous silicon.

Further, in the solar cell 10D having the double junction structure shown in FIG. 4, the second i-type semiconductor layer 432 of the second photoelectric transformation unit 430 may be doped with germanium (Ge) as impurities. Germanium may reduce a band gap of the second i-type semiconductor layer 432. Hence, an absorptance of the second i-type semiconductor layer 432 with respect to the light of a long wavelength band may increase. As a result, the efficiency of the solar cell 10D may be improved.

In other words, in the solar cell 10D having the double junction structure, the first i-type semiconductor layer 422 may absorb light of a short wavelength band to provide the photoelectric transformation effect, and the second i-type semiconductor layer 432 may absorb light of a long wavelength band to provide the photoelectric transformation effect. Further, because the band gap of the second i-type semiconductor layer 432 doped with Ge may be reduced, the second i-type semiconductor layer 432 may absorb a large amount of light of a long wavelength band. As a result, the efficiency of the solar cell 10D may be improved.

The PECVD method may be used to dope the second i-type semiconductor layer 432 with Ge. In the PECVD method, a very high frequency (VHF), a high frequency (HF), or a radio frequency (RF) may be applied to a chamber filled with Ge gas.

In the embodiment of the invention, an amount of Ge contained in the second i-type semiconductor layer 432 may be about 3 to 20 atom%. When the amount of Ge is within the above range, the band gap of the second i-type semiconductor layer 432 may be sufficiently reduced. Hence, an absorptance of the second i-type semiconductor layer 432 with respect to light of a long wavelength band may increase.

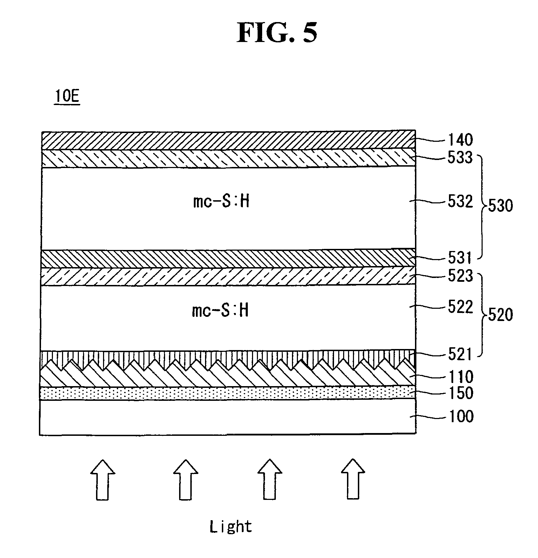

Alternatively, as shown in FIG. 5, the solar cell 10E having the double junction structure may include a first photoelectric transformation unit 520 including a first i-type semiconductor layer 522 containing microcrystalline silicon and a second photoelectric transformation unit 530 including a second i-type semiconductor layer 532 containing microcrystalline silicon. In other words, both the first i-type semiconductor layer 522 and the second i-type semiconductor layer 532 may contain microcrystalline silicon.

Even in the solar cells 10C to 10E having the double junction structure shown in FIGS. 3 to 5, the buffer layer 150 may be positioned between the substrate 100 and the transparent electrode 110. The buffer layer 150 is described in detail below.

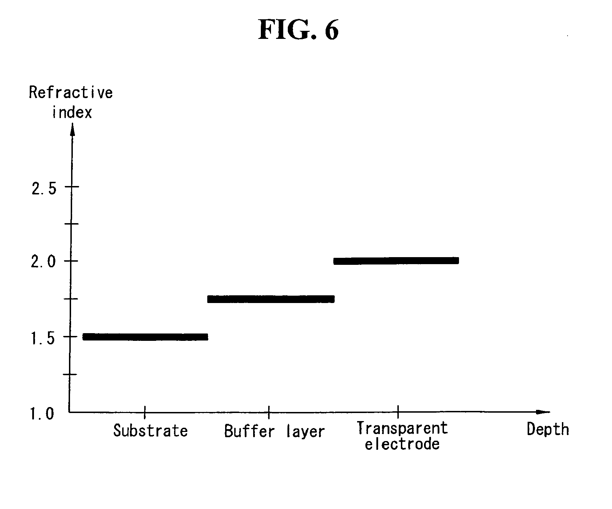

As shown in FIG. 6, which is the same as FIG. 5, a refractive index of the buffer layer 150 positioned between the substrate 100 and the transparent electrode 110 may be greater than a refractive index of the substrate 100 and may be less than a refractive index of the transparent electrode 110. Preferably, but not necessarily, the refractive index of the buffer layer 150 may be set to about 1.5 to 2.0, so that the refractive index of the buffer layer 150 is greater than the refractive index of the substrate 100 and is less than the refractive index of the transparent electrode 110.

As above, when the buffer layer 150 is positioned between the substrate 100 and the transparent electrode 110, the light reflectance of the solar cell 10E may be reduced. Hence, the efficiency of the solar cell 10E may be improved.

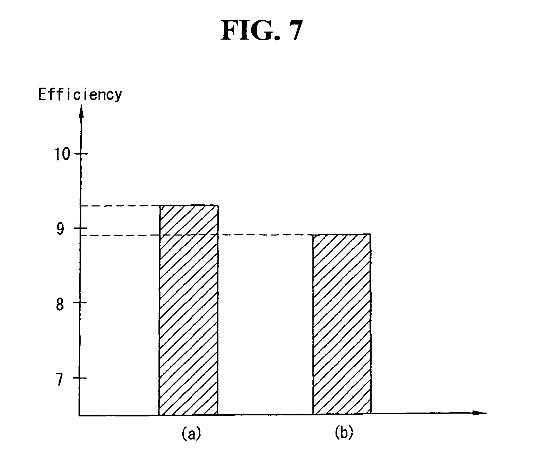

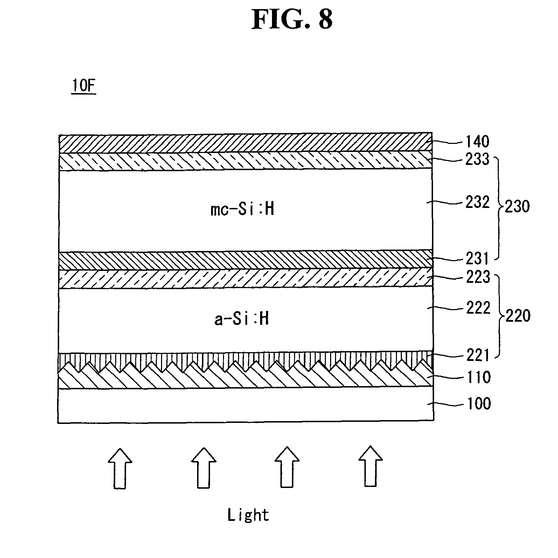

FIG. 7 illustrates an efficiency of the solar cell according to the example embodiment of the invention and an efficiency of a solar cell according to a comparative example not including the buffer layer 150. In FIG. 7, (a) indicates the efficiency of the solar cell having the double junction structure shown in FIG. 3, and (b) indicates the efficiency of the solar cell having the double junction structure shown in FIG. 8 in which the substrate 100 and the transparent electrode 110 directly contact each other because of the absence of the buffer layer 150.

As shown in FIG. 7, the efficiency shown by (b) of the solar cell according to the comparative example not including the buffer layer 150 was approximately 8.9 %. On the other hand, the efficiency shown by (a) of the solar cell according to the example embodiment of the invention including the buffer layer 150 between the substrate 100 and the transparent electrode 110 was approximately 9.3 %. Consequently, the efficiency shown by (a) of the solar cell according to an example embodiment of the invention increased further than the efficiency shown by (b) of the solar cell according to the comparative example by about 0.45%.

The increase in the efficiency of the solar cells according to the example embodiments of the invention may be achieved because the buffer layer 150 between the substrate 100 and the transparent electrode 110 reduces the reflectance of light incident on the solar cells.

As above, the buffer layer 150 between the substrate 100 and the transparent electrode 110 may reduce the reflectance of light incident on the solar cells by gradually varying a refractive angle of the incident light. A thickness of the buffer layer 150 for performing a reduction in the reflectance of light may have a sufficient small value. It may be preferable, but not required, that the thickness of the buffer layer 150 is less than the thickness of the transparent electrode 110.

The material of the buffer layer 150 is not particularly limited as long as the refractive index of the buffer layer 150 is greater than the refractive index of the substrate 100 and is less than the refractive index of the transparent electrode 110. It may be preferable, but not required, that the buffer layer 150 is formed of at least one of SiOxNy, SiOx, and SiNx in consideration of the manufacturing cost, the ease of manufacturing process, etc. Further, the buffer layer 150 may have a single-layered structure formed of one of SiOxNy, SiOx, and SiNx.

When the buffer layer 150 is formed of at least one of SiOxNy, SiOx, and SiNx, it may be preferable, but not required, that the substrate 100 is a glass substrate. In this instance, the affinity between the buffer layer 150 and the substrate 100 may be improved. Hence, a structural strength of the solar cell may be improved.

It may be preferable, but not required, that the transparent electrode 110 contains ZnO:Al . Because the transparent electrode 110 containing ZnO:Al has a surface with characteristics that can be easily controlled using a chemical etching method, uneven portions having a relatively small reflectance may be easily formed on the transparent electrode 110.

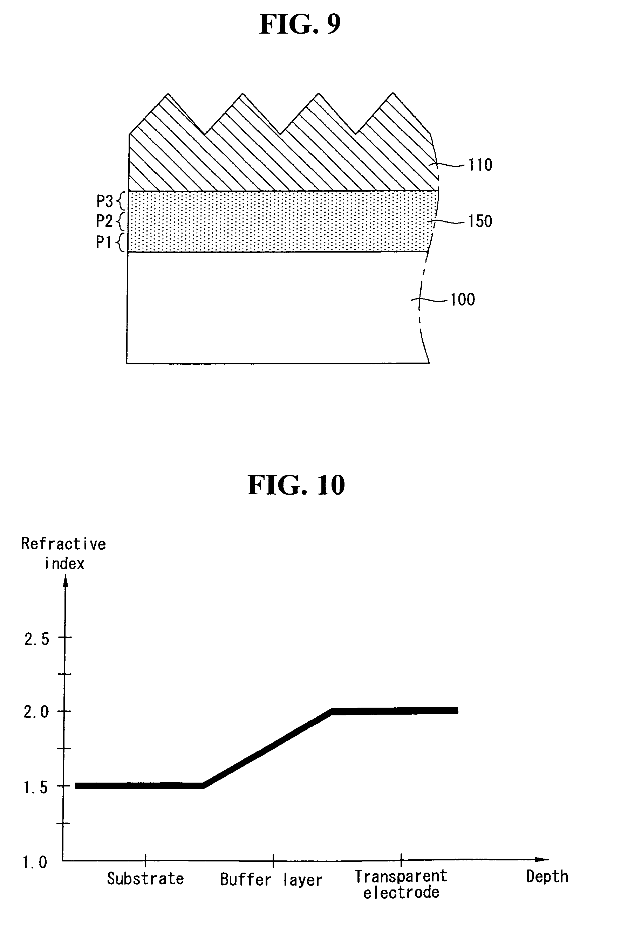

The buffer layer 150 may include a plurality of portions each having a different refractive index. For example, as shown in FIG. 9, the buffer layer 150 may include a first portion P1 and a second portion P2 each having a different refractive index. The first portion P 1 may be positioned between the second portion P2 and the substrate 100, and a refractive index of the first portion P1 may be less than a refractive index of the second portion P2.

Alternatively, the refractive index of the third portion P3 may be greater than the refractive indexes of the first and second portions P1 and P2, under condition that the refractive indexes of the first, second, and third portions P1, P2, and P3 are greater than the refractive index of the substrate 100 and is less than the refractive index of the transparent electrode 110. Even in this instance, the reflectance of the solar cell according to the embodiment of the invention may be less than the reflectance of the solar cell not including the buffer layer 150.

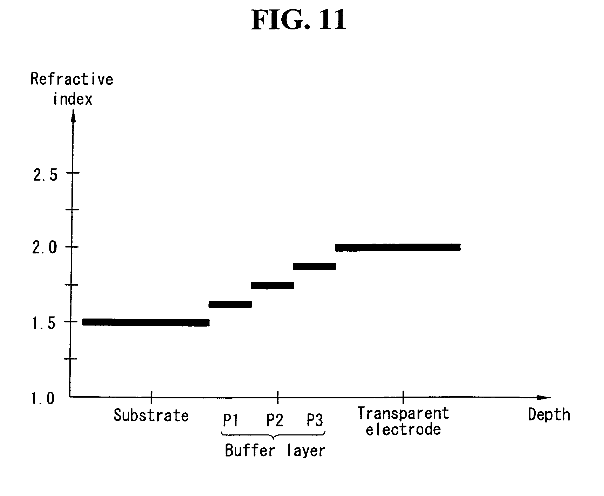

The refractive index of each of the first, second, and third portions P1, P2, and P3 is indicated in FIG. 10, whereby the refractive index of the buffer layer 150 may gradually increase as the buffer layer 150 goes from the substrate 100 to the transparent electrode 110. Alternatively, the refractive index of each of the first, second and third portions P1, P2 and P3 may be as indicated in FIG. 11, whereby the refractive index of the buffer layer 150 (i.e., the refractive index of each of the first, second and third portions P1, P2 and P3) may abruptly increase as the buffer layer 150 goes from the substrate 100 to the transparent electrode 110. Alternatively, the buffer layer 150 may further include a third portion P3 between the first portion P1 and the second portion P2. A refractive index of the third portion P3 may be greater than the refractive index of the first portion P1 and may be less than the refractive index of the second portion P2.

An example method for manufacturing the buffer layer 150 is described below.

A plasma discharge may be generated in a chamber, into which a silicon (Si) gas, an oxygen (O₂) gas, and a nitrogen (N₂) gas are injected, to form therefrom the buffer layer 150 of SiOxNy. The refractive index of the buffer layer 150 formed of SiOxNy may be controlled within the range between about 1.5 and 2.0 by controlling an amount of at least one of the oxygen (O₂) gas and the nitrogen (N₂) gas injected into the chamber. When the buffer layer 150 is formed of SiOx or SiNx, various methods may be used to control the refractive index of the buffer layer 150.

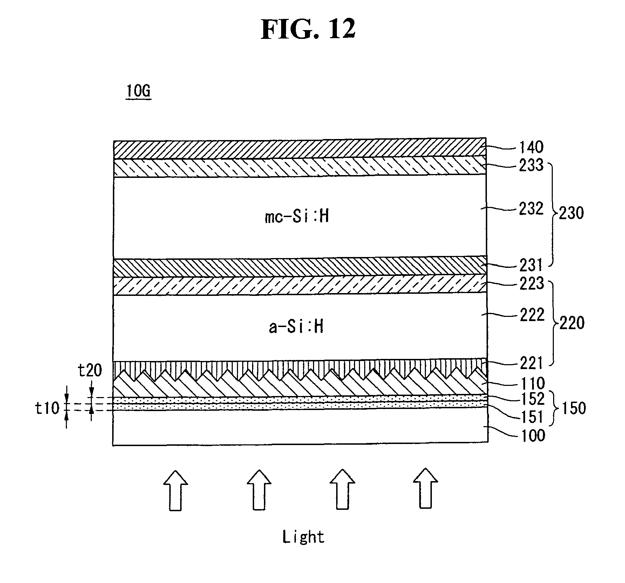

FIGS. 12 to 18 relate to configurations of solar cells with the buffer layer having a multi-layered structure.

The buffer layer 150 may have a multi-layered structure. For example, as shown in FIG. 12, the buffer layer 150 may include a first layer 151 and a second layer 152. The first layer 151 may be positioned between the second layer 152 and the substrate 100. It may be preferable, but not required, that a thickness t10 of the first layer 151 and a thickness t20 of the second layer 152 are less than the thickness of the transparent electrode 110, either individually or in combination.

Even in this instance, the refractive index of the buffer layer 150 may be greater than the refractive index of the substrate 100 and may be less than the refractive index of the transparent electrode 110. In other words, a refractive index of the first layer 151 and a refractive index of the second layer 152 may be greater than the refractive index of the substrate 100 and may be less than the refractive index of the transparent electrode 110.

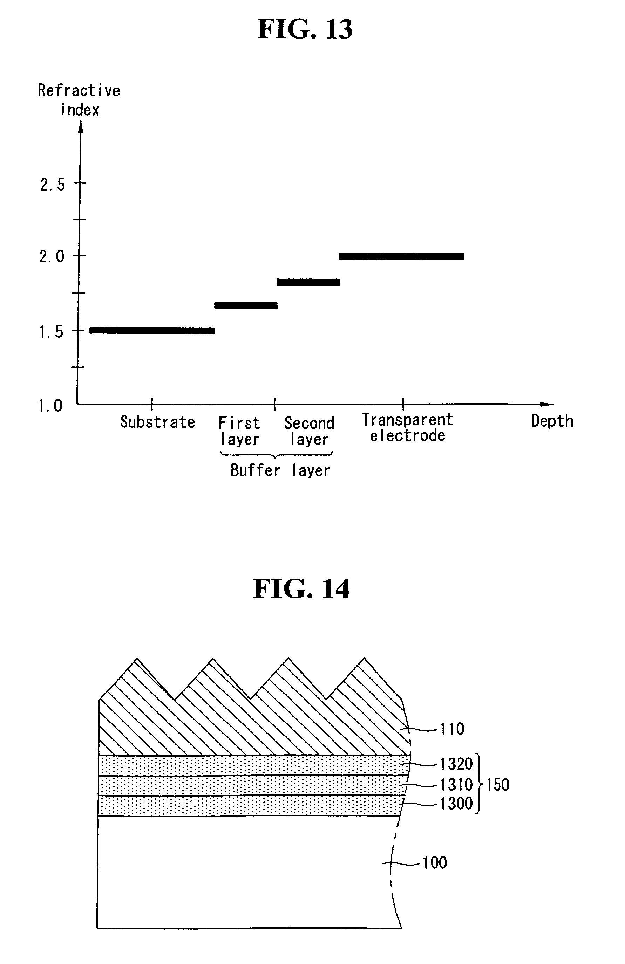

Further, as shown in FIG. 13, the refractive index of the first layer 151 may be less than the refractive index of the second layer 152, so as to reduce the reflectance of the solar cell 10.

With reference to FIG. 12, the buffer layer 150 including the first layer 151 and the second layer 152 may include a SiOxNy layer and a SiOx layer. Alternatively, the buffer layer 150 including the first layer 151 and the second layer 152 may include a SiOx layer and a SiNx layer. Alternatively, the buffer layer 150 including the first layer 151 and the second layer 152 may include a SiOxNy layer and a SiNx layer.

For example, the first layer 151 may be the SiOx layer, and the second layer 152 may be the SiNx layer. In this instance, as shown in FIG. 13, the refractive index of the first layer 151 may be less than the refractive index of the second layer 152.

Alternatively, the first layer 151 may be the SiOx layer, and the second layer 152 may be the SiOxNy layer. In this instance, as shown in FIG. 13, the refractive index of the first layer 151 may be less than the refractive index of the second layer 152.

Alternatively, the first layer 151 may be the SiOxNy layer, and the second layer 152 may be the SiNx layer. In this instance, as shown in FIG. 13, the refractive index of the first layer 151 may be less than the refractive index of the second layer 152.

Further, as shown in FIG. 14, the buffer layer 150 may include a first layer 1300, a second layer 1310, and a third layer 1320.

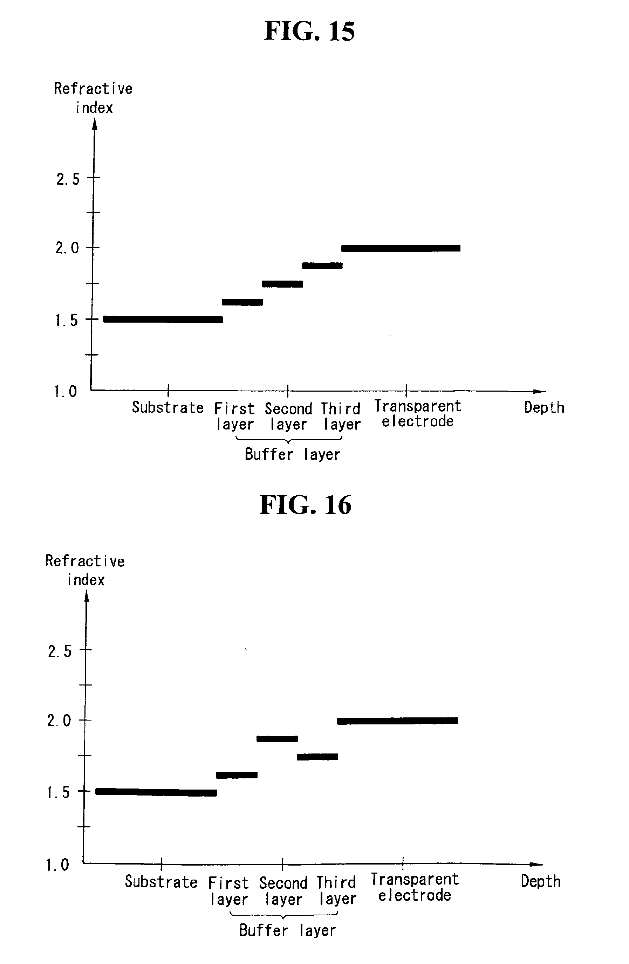

In this instance, as shown in FIG. 15, a refractive index of the first layer 1300 positioned between the second layer 1310 and the substrate 100 may be less than a refractive index of the second layer 1310, and the refractive index of the second layer 1310 positioned between the first layer 1300 and the third layer 1320 may be less than a refractive index of the third layer 1320. Further, the refractive indexes of the first layer 1300, the second layer 1310, and the third layer 1320 may be greater than the refractive index of the substrate 100 and may be less than the refractive index of the transparent electrode 110.

The buffer layer 150 including the first, second, and third layers 1300, 1310, and 1320 may include a SiOxNy layer, a SiOx layer, and a SiNx layer. It may be preferable, but not required, that the first layer 1300 may be the SiOx layer, the second layer 1310 may be the SiOxNy layer, and the third layer 1320 may be the SiNx layer, so that the refractive index of the second layer 1310 is greater than the refractive index of the first layer 1300 and the refractive index of the third layer 1320 is greater than the refractive index of the second layer 1310 as shown in FIG. 15.

Alternatively, two layers of the first, second, and third layers 1300, 1310, and 1320 may be formed of the same material. For example, the first layer 1300 maybe the SiOx layer, and the second and third layers 1310 and 1320 may be the SiOxNy layer. In this instance, the refractive index of the second layer 1310 and the refractive index of the third layer 1320 may be substantially equal to each other, or the refractive index of the third layer 1320 may be greater than the refractive index of the second layer 1310.

Alternatively, as shown in FIG. 16, the refractive index of the second layer 1310 may be greater than the refractive index of the first layer 1300 and the refractive index of the third layer 1320. Even in this instance, the reflectance of the solar cell according to the embodiment of the invention may be less than the reflectance of the solar cell not including the buffer layer 150. As a result, the efficiency of the solar cell may be improved.

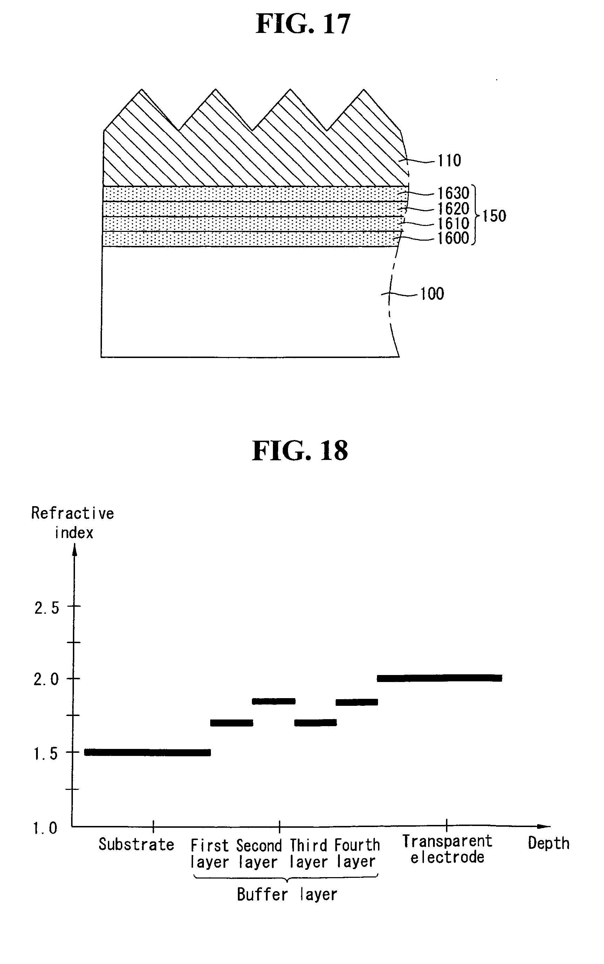

Further, as shown in FIG. 17, the buffer layer 150 may include a first layer 1600, a second layer 1610, a third layer 1620, and a fourth layer 1630.

In this instance, refractive indexes of the first layer 1600, the second layer 1610, the third layer 1620, and the fourth layer 1630 may sequentially increase in the order named. It may be preferable, but not required, that the refractive indexes of the first layer 1600, the second layer 1610, the third layer 1620, and the fourth layer 1630 are greater than the refractive index of the substrate 100 and are less than the refractive index of the transparent electrode 110.

Alternatively, as shown in FIG. 18, the refractive index of the second layer 1610 may be greater than the refractive indexes of the first layer 1600 and the third layer 1620. Further, the refractive index of the first layer 1600 may be substantially equal to the refractive index of the third layer 1620, and the refractive index of the second layer 1610 may be substantially equal to the refractive index of the fourth layer 1630. In an example embodiment, at least one of the refractive indexes of the first layer 1600, the second layer 1610, the third layer 1620, and the fourth layer 1630 may be greater than the refractive index of the substrate 100 and be less than the refractive index of the transparent electrode 110.

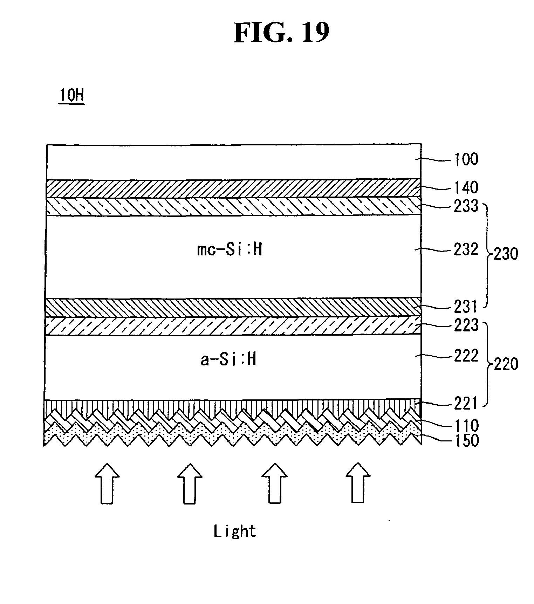

FIG. 19 illustrates another configuration of a solar cell having a buffer layer according to an example embodiment of the invention. In the following explanations, structural elements having the same functions and structures as those discussed previously are designated by the same reference numerals, and the explanations therefore will not be repeated unless they are necessary.

As shown in FIG. 19, a substrate 100 of a solar cell 10H according to an example embodiment of the invention may be positioned opposite a light incident surface. Thus, in such a structure shown in FIG. 19, because light is incident on the opposite side of the substrate 100, i.e., on a transparent electrode 110, the substrate 100 does not need to be substantially transparent. Therefore, the substrate 100 may be formed of opaque metal which is other than glass and plastic. The solar cell 10H having the structure shown in FIG. 19 may be referred to as an nip-type solar cell.

In the solar cell 10H having the structure shown in FIG. 19, a buffer layer 150 may be positioned on a front surface of the transparent electrode 110.

The solar cells shown in FIGS. 1-6 and 12 have the structure in which the buffer layer 150 is positioned between the transparent electrode 110 and the substrate 100. On the other hand, the solar cell 10H shown in FIG. 19 has the structure in which the buffer layer 150 is positioned on the front surface of the transparent electrode 110, i.e., the light incident surface.

In the solar cell 10H shown in FIG. 19, it may be preferable, but not required, that a refractive index of the buffer layer 150 is less than a refractive index of the transparent electrode 110. Further, because the buffer layer 150 is positioned on the front surface of the transparent electrode 110, the buffer layer 150 may have uneven portions, or may be formed unevenly.

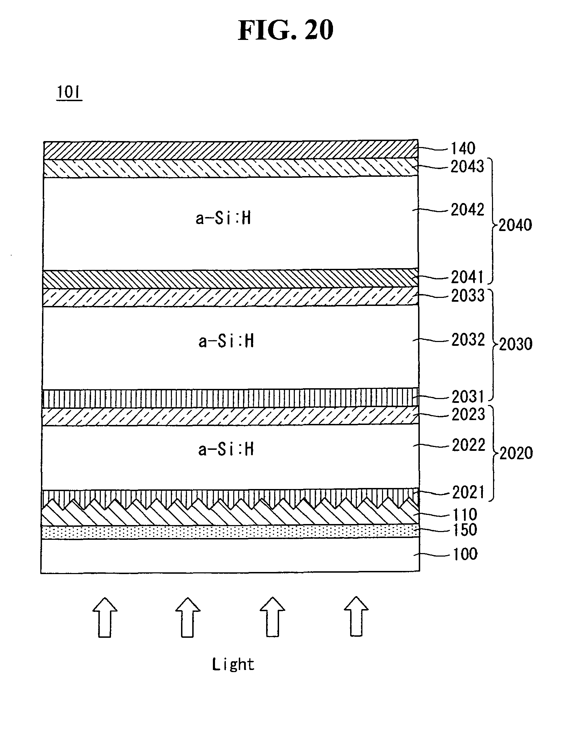

FIGS. 20 to 22 relate to triple junction solar cells having a buffer layer according to an example embodiment of the invention. In the following explanations, structural elements having the same functions and structures as those discussed previously are designated by the same reference numerals, and the explanations therefore will not be repeated unless they are necessary.

A triple junction solar cell 10I shown in FIG. 20 may be referred to as a pin-pin-pin type solar cell.

As shown in FIG. 20, the triple junction solar cell 10I according to the example embodiment of the invention may include a first photoelectric transformation unit 2020, a second photoelectric transformation unit 2030, and a third photoelectric transformation unit 2040 that are sequentially positioned on a light incident surface of a substrate 100 in the order named.

The first photoelectric transformation unit 2020 may include a first p-type semiconductor layer 2021, a first i-type semiconductor layer 2022, and a first n-type semiconductor layer 2023. The second photoelectric transformation unit 2030 may include a second p-type semiconductor layer 2031, a second i-type semiconductor layer 2032, and a second n-type semiconductor layer 2033. The third photoelectric transformation unit 2040 may include a third p-type semiconductor layer 2041, a third i-type semiconductor layer 2042, and a third n-type semiconductor layer 2043.

The first photoelectric transformation unit 2020 may be an amorphous silicon cell using amorphous silicon, for example, hydrogenated amorphous silicon (a-Si:H). The first i-type semiconductor layer 2022 of the first photoelectric transformation unit 2020 may be formed of hydrogenated amorphous silicon (a-Si:H) and may absorb light of a short wavelength band, thereby producing electric power.

The second photoelectric transformation unit 2030 may be an amorphous silicon cell using amorphous silicon, for example, hydrogenated amorphous silicon (a-Si:H). The second i-type semiconductor layer 2032 of the second photoelectric transformation unit 2030 may be formed of hydrogenated amorphous silicon (a-Si:H) and may absorb light of a middle wavelength band between a short wavelength band and a long wavelength band, thereby producing electric power.

The third photoelectric transformation unit 2040 may be an amorphous silicon cell using amorphous silicon, for example, hydrogenated amorphous silicon (a-Si:H). The third i-type semiconductor layer 2042 of the third photoelectric transformation unit 2040 may be formed of hydrogenated amorphous silicon (a-Si:H) and may absorb light of a long wavelength band, thereby producing electric power.

A thickness of the third i-type semiconductor layer 2042 may be greater than a thickness of the second i-type semiconductor layer 2032, and the thickness of the second i-type semiconductor layer 2032 may be greater than a thickness of the first i-type semiconductor layer 2022.

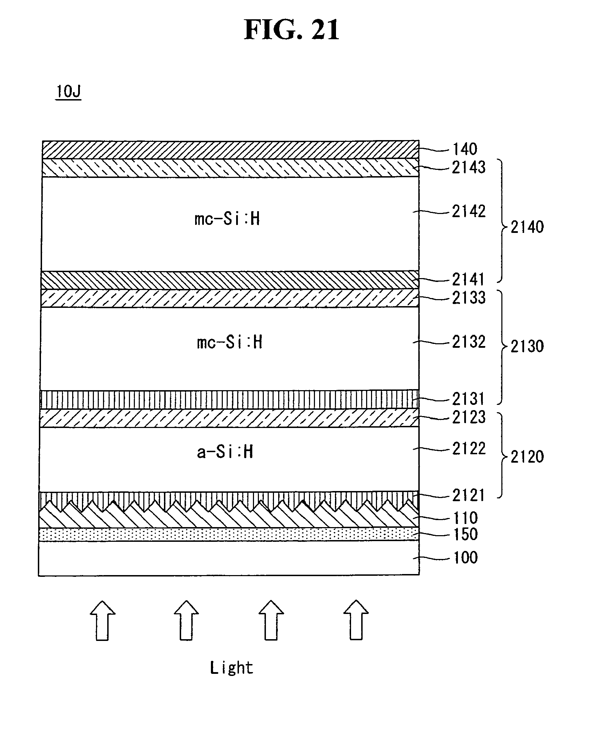

Alternatively, as shown in FIG. 21, the solar cell 10J according to the embodiment of the invention may include a first photoelectric transformation unit 2120 formed of amorphous silicon, a second photoelectric transformation unit 2130 formed of microcrystalline silicon (mc-Si), and a third photoelectric transformation unit 2140 formed of microcrystalline silicon (mc-Si). In other words, both a second i-type semiconductor layer 2132 and a third i-type semiconductor layer 2142 may be formed of microcrystalline silicon (mc-Si).

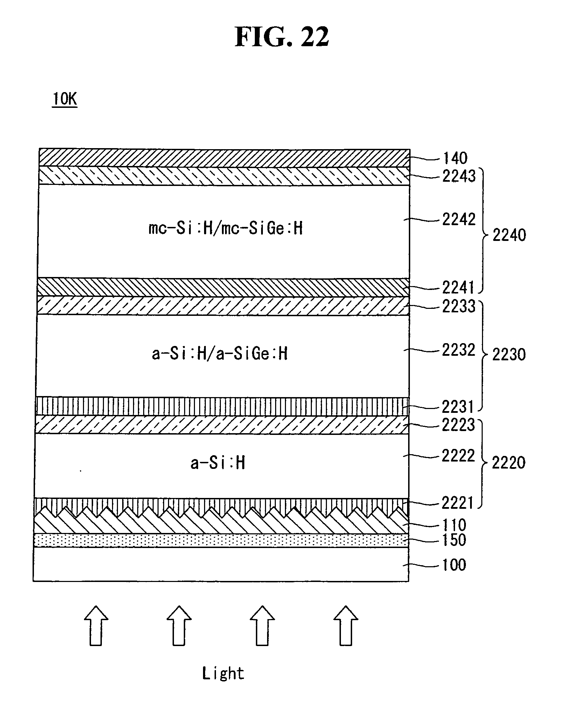

Alternatively, as shown in FIG. 22, the solar cell 10K according to the embodiment of the invention may include a first photoelectric transformation unit 2220 formed of amorphous silicon, a second photoelectric transformation unit 2230 formed of amorphous silicon, and a third photoelectric transformation unit 2240 formed of microcrystalline silicon (mc-Si).

Even in the triple junction solar cells 10I to 10K shown in FIGS. 20 to 22, it may be preferable, but not required, that the buffer layer 150 is positioned between the substrate 100 and the transparent electrode 110.

Further, in the triple junction solar cell 10K shown in FIG. 22, both a second i-type semiconductor layer 2232 and a third i-type semiconductor layer 2242 may be doped with germanium (Ge) as impurities, so that the photoelectric transformation efficiency of the triple junction solar cell 10K is further improved. Alternatively, only the second i-type semiconductor layer 2232 may be doped with germanium (Ge) as impurities.

Thus, as it was similarly described previously with reference to FIG. 4, the efficiency of the solar cell 10K may be further improved by further increasing the absorptance of the solar cell 10K with respect to light of the long wavelength band.

Although embodiments have been described with reference to a number of illustrative embodiments thereof, it should be understood that numerous other modifications and embodiments can be devised by those skilled in the art that will fall within the scope of the principles of this disclosure. More particularly, various variations and modifications are possible in the component parts and/or arrangements of the subject combination arrangement within the scope of the disclosure, the drawings and the appended claims. In addition to variations and modifications in the component parts and/or arrangements, alternative uses will also be apparent to those skilled in the art.

## Claims

1. A solar cell comprising:
a substrate;
a photoelectric transformation unit including at least one semiconductor layer;
a transparent electrode positioned between the substrate and the photoelectric transformation unit; and
a buffer layer positioned between the transparent electrode and the substrate.

2. The solar cell of claim 1, wherein the photoelectric transformation unit includes at least one p-type semiconductor layer, at least one n-type semiconductor layer, and at least one i-type semiconductor layer.

3. The solar cell of claim 1, wherein the transparent electrode contains ZnO:Al.

4. The solar cell of claim 1, wherein a refractive index of the buffer layer is greater than a refractive index of the substrate and is less than a refractive index of the transparent electrode.

5. The solar cell of claim 4, wherein the refractive index of the buffer layer is approximately 1.5 to 2.0.

6. The solar cell of claim 1, wherein the buffer layer is formed of at least one of SiOxNy, SiOx, and SiNx.

7. The solar cell of claim 6, wherein the substrate is a glass substrate.

8. The solar cell of claim 1, wherein the buffer layer includes a first portion, and a second portion positioned between the first portion and the transparent electrode, and a refractive index of the first portion is less than a refractive index of the second portion.

9. The solar cell of claim 1, wherein a thickness of the buffer layer is less than a thickness of the transparent electrode.

10. The solar cell of claim 1, wherein the buffer layer includes a first layer adjacent to the substrate and a second layer adjacent to the transparent electrode,
a refractive index of the first layer is less than a refractive index of the second layer, and
the refractive index of the first layer and the refractive index of the second layer are greater than a refractive index of the substrate and are less than a refractive index of the transparent electrode.

11. The solar cell of claim 1, wherein the buffer layer includes a first layer adjacent to the substrate, a second layer adjacent to the transparent electrode, and a third layer positioned between the first layer and the second layer,
a refractive index of the third layer is greater than a refractive index of at least one of the first layer and the second layer, and
the refractive indexes of the first, second, and third layers are greater than a refractive index of the substrate and are less than a refractive index of the transparent electrode.

12. The solar cell of claim 1, wherein the buffer layer has a single-layered structure formed of one of SiOxNy, SiOx, and SiNx.

13. The solar cell of claim 1, wherein the buffer layer has a multi-layered structure formed of a SiOxNy layer and a SiOx layer.

14. The solar cell of claim 1, wherein the buffer layer has a multi-layered structure formed of a SiOx layer and a SiNx layer.

15. The solar cell of claim 1, wherein the buffer layer has a multi-layered structure formed of a SiOxNy layer and a SiNx layer.
